# FASCICULE DE BREVET EUROPEEN

(11) **EP 3 975 584 B1**
(45) Date de publication et mention de la délivrance du brevet: **28.08.2024**
(21) Numéro de dépôt: 21199172.4
(22) Date de dépôt: 27.09.2021
(51) Int. Cl.: H04R 19/00, B81C 1/00, H04R 31/00

(54) **PROCÉDÉ DE FABRICATION D'UN TRANSDUCTEUR ELECTROACOUSTIQUE**
VERFAHREN ZUR HERSTELLUNG EINES ELEKTROAKUSTISCHEN TRANSDUCERS
METHOD FOR MANUFACTURING AN ELECTROACOUSTIC TRANSDUCER

(30) Priorité: 29.09.2020 FR 2009918
(43) Date de publication de la demande: 30.03.2022
(73) Titulaire: Commissariat à l'Energie Atomique et aux Energies Alternatives, 75015 Paris (FR)
(72) Inventeur: JOET, Loïc, 38054 GRENOBLE CEDEX 09 (FR)
(74) Mandataire: Cabinet Camus Lebkiri

(56) Documents cités:
- EP-A1- 2 541 222
- EP-A1- 3 070 963
- EP-A1- 3 557 881

## Description

### DOMAINE TECHNIQUE DE L'INVENTION

Le domaine technique de l'invention est celui des dispositifs de type microsystèmes électromécaniques (MEMS, pour « microelectromechanical systems » en anglais) ou nanosystèmes électromécaniques (NEMS, pour « nanoelectromechanical systems »). L'invention concerne plus particulièrement un procédé de fabrication d'un transducteur électroacoustique comprenant un dispositif de transmission d'un mouvement et d'une force entre deux zones isolées l'une de l'autre de manière étanche. Un tel transducteur électroacoustique peut être employé en tant que microphone ou haut-parleur.

### ARRIERE-PLAN TECHNOLOGIQUE DE L'INVENTION

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. La demande de brevet FR3059659 décrit un exemple de microphone à détection capacitive comprenant un élément mobile, des moyens de détection capacitive et un dispositif de transmission d'un mouvement entre l'élément mobile et les moyens de détection capacitive.

L'élément mobile est capable de récolter la variation de pression. Il peut être formé par un piston rigide comprenant une membrane, aussi appelée couche mince, et une structure de rigidification de la membrane. La membrane forme une séparation entre une cavité ouverte sur l'environnement extérieur et un volume arrière du microphone, aussi appelé volume de référence car il y règne une pression de référence. Ainsi, une face de la membrane est soumise à la pression de référence et une face opposée de la membrane est soumise à la pression atmosphérique (dont on souhaite détecter la variation). L'élément mobile est relié au dispositif de transmission de mouvement dans une première zone du microphone.

Les moyens de détection capacitive permettent de mesurer le déplacement du piston, et donc la variation de pression. Ils sont disposés dans une deuxième zone isolée de la première zone de manière étanche. Ils comprennent une électrode mobile et au moins une électrode fixe disposée en regard de l'électrode mobile. Les électrodes forment les armatures d'un condensateur dont la capacité varie en fonction du déplacement du piston. La deuxième zone est une chambre sous atmosphère contrôlée (typiquement sous vide) pour réduire les phénomènes de frottement visqueux et les bruits associés.

Le dispositif de transmission comprend au moins un premier bras de transmission s'étendant dans la première zone et au moins un deuxième bras de transmission s'étendant dans la deuxième zone. Le piston est couplé à une première extrémité du premier bras de transmission, tandis que l'électrode mobile des moyens de détection capacitive est couplée à une extrémité du deuxième bras de transmission. Les premier et deuxième bras de transmission sont reliés à leur deuxième extrémité par l'intermédiaire d'une articulation pivot. Cette articulation pivot autorise une rotation des bras de transmission par rapport au bâti du microphone et assure simultanément l'étanchéité entre les première et deuxième zones.

La fabrication d'un tel microphone comprend notamment une étape de détourage du piston et une étape de délimitation des bras de transmission, afin de les rendre mobiles par rapport au bâti. Ces étapes sont difficiles à mettre en oeuvre sans percer le piston et créer des fuites d'air importantes entre la cavité soumise à la pression atmosphérique et le volume arrière du microphone (soumis à la pression de référence).

Par ailleurs, le document EP3070963A1 décrit un transducteur électroacoustique de type microphone comprenant un support, un élément sensible ancré au support au moyen de poutres mobiles en rotation et des moyens de détection de l'effort appliqué à l'élément sensible par une différence de pression de part et d'autre de l'élément sensible. L'élément sensible (ou piston) comporte une membrane et des moyens de rigidification de la membrane. Les poutres transmettent l'effort entre l'élément sensible et les moyens de détection. Les moyens de détection comportent au moins une jauge de contrainte, avantageusement une jauge piézoélectrique.

Les documents EP2541222A1 et EP3557881A1 présentent d'autres transducteurs électroacoustiques de l'état de l'art.

### RESUME DE L'INVENTION

De manière plus générale, il existe un besoin de fabriquer un transducteur électroacoustique tout en limitant les fuites d'air entre les différents volumes du transducteur électroacoustique, le transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission.

Selon un premier aspect de l'invention, on tend à satisfaire ce besoin en prévoyant un procédé de fabrication comprenant les étapes suivantes :
- prévoir un empilement comprenant successivement un substrat, une première couche sacrificielle et une première couche structurelle ;
- graver la première couche structurelle jusqu'à la première couche sacrificielle de façon à séparer une première partie de la première couche structurelle et une deuxième partie de la première couche structurelle, la première partie de la première couche structurelle étant destinée à former la membrane de l'élément mobile ;
- former une deuxième couche sacrificielle comprenant :
   - une première portion disposée sur la première partie de la première couche structurelle ;
   - une deuxième portion espacée de la première portion et disposée sur la première couche structurelle ; et
   - une troisième portion adjacente à la deuxième portion et disposée sur la première couche sacrificielle entre les première et deuxième parties de la première couche structurelle ;
- former une deuxième couche structurelle sur la deuxième couche sacrificielle ;
- graver la deuxième couche structurelle de façon à délimiter la structure de rigidification de l'élément mobile et de façon à exposer la première portion de la deuxième couche sacrificielle ;
- graver la deuxième couche sacrificielle de façon à exposer la première partie de la première couche structurelle ;
- graver le substrat jusqu'à la première couche sacrificielle de façon à délimiter le premier bras de transmission ; et
- graver la première couche sacrificielle de façon à rendre mobile la première partie de la première couche structurelle.

En outre, la gravure de la première couche structurelle et la gravure de la deuxième couche structurelle délimitant la périphérie de la structure de rigidification sont espacées l'une de l'autre dans une région autour de la position du premier bras de transmission, de sorte que la deuxième portion de la deuxième couche sacrificielle serve de couche d'arrêt à la gravure de la deuxième couche structurelle.

Dans la région où se croisent le premier bras de transmission et la périphérie de la structure de rigidification, la deuxième portion de la deuxième couche sacrificielle recouvre la première couche structurelle. La première couche structurelle n'est alors pas affectée par la gravure de la deuxième couche structurelle. En outre, en éloignant la gravure de la première couche structurelle et la gravure de la deuxième couche structurelle, l'intégrité de la première couche sacrificielle peut être préservée au niveau du premier bras de transmission après l'étape de gravure de la deuxième couche sacrificielle. Le substrat peut alors être gravé pour délimiter le premier bras de transmission sans risque que la gravure ne se propage à la première couche structurelle et à la deuxième couche structurelle. Le risque de créer des fuites d'air de part et d'autre du premier bras de transmission est alors écarté.

Dans un mode de mise en oeuvre préférentiel du procédé de fabrication, la première couche structurelle est gravée en dehors de ladite région de sorte que la troisième portion de la deuxième couche sacrificielle s'étende au moins jusqu'à la périphérie de la structure de rigidification.

La gravure de la première couche structurelle et la gravure de la deuxième couche structurelle peuvent être espacées l'une de l'autre au moyen d'un décroché de la première couche structurelle et/ou d'un décroché de la deuxième couche structurelle.

La deuxième portion de la deuxième couche sacrificielle peut être disposée sur la première partie de la première couche structurelle ou sur la deuxième partie de la première couche structurelle.

Avantageusement, le procédé de fabrication comprend en outre, après l'étape de gravure de la deuxième couche sacrificielle et avant l'étape de gravure du substrat, les étapes suivantes :
- disposer un capot sur la deuxième couche structurelle, formant ainsi un assemblage ; et
- retourner l'assemblage.

Outre les caractéristiques qui viennent d'être évoquées dans les paragraphes précédents, le procédé de fabrication selon l'invention peut présenter une ou plusieurs caractéristiques complémentaires parmi les suivantes, considérées individuellement ou selon toutes les combinaisons techniquement possibles :
- la structure de rigidification de l'élément mobile repose au moins en partie sur la première partie de la première couche structurelle ;
- la structure de rigidification de l'élément mobile est en contact avec la première partie de la première couche structurelle ;
- l'empilement est une structure multicouche de type silicium sur isolant (SOI) ;
- le substrat est en silicium, la première couche sacrificielle est en oxyde de silicium et la première couche structurelle est en silicium ;
- la deuxième couche sacrificielle est en oxyde de silicium ; et
- la première couche structurelle présente une épaisseur comprise entre 100 nm et 10 µm.

Un deuxième aspect de l'invention concerne un transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission ;
la membrane étant formée par une première partie d'une première couche structurelle, la structure de rigidification étant formée par une première partie d'une deuxième couche structurelle disposée sur la première couche structurelle, le bâti comprenant une première partie d'un substrat, une deuxième partie de la première couche structurelle et une deuxième partie de la deuxième couche structurelle, le premier bras de transmission étant formé d'une deuxième partie du substrat.

Dans un mode de réalisation de l'invention, l'une des première et deuxième parties de la première couche structurelle présente décroché en regard de l'autre des première et deuxième parties, le décroché étant situé dans une région autour d'une intersection entre la position du premier bras de transmission et la périphérie de la structure de rigidification.

Dans un autre mode de réalisation de l'invention, l'une des première et deuxième parties de la deuxième couche structurelle présente un décroché en regard de l'autre des première et deuxième parties, le décroché étant situé dans une région autour d'une intersection entre la position du premier bras de transmission et la périphérie de la structure de rigidification.

Dans un mode de réalisation préférentiel, le transducteur comprend un dispositif de transmission d'un mouvement et d'une force entre une première zone et une deuxième zone à atmosphère contrôlée, les première et deuxième zones étant isolées l'une de l'autre de manière étanche, le dispositif de transmission comprenant, outre le premier bras de transmission qui s'étend dans la première zone, un deuxième bras de transmission s'étendant dans la deuxième zone.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1] représente schématiquement et partiellement un exemple de transducteur électroacoustique comprenant un piston relié à deux premiers bras de transmission ;
[Fig. 2A] à [Fig. 2H] représentent des étapes d'un procédé de fabrication du transducteur électroacoustique selon la figure 1 ;
[Fig. 3] est une vue en perspective du transducteur électroacoustique après l'étape de libération de la membrane du piston représentée par la figure 2H ;
[Fig. 4A] à [Fig. 4D] représentent des étapes d'un procédé de fabrication de transducteur électroacoustique selon l'invention ;
[Fig. 5] est une vue en coupe du transducteur électroacoustique, après que les étapes des figures 4A-4D et 2F-2H aient été accomplies, à l'intersection entre la périphérie du piston et la position d'un premier bras de transmission ;
[Fig. 6] est une vue en coupe du transducteur électroacoustique, après que les étapes 4A-4D ait été accomplies selon un mode de mise en oeuvre préférentiel du procédé de fabrication, afin de diminuer le phénomène d'amortissement ;
[Fig. 7A] à [Fig. 7D] représentent des masques de gravure pouvant être utilisés pour accomplir les étapes des figures 4A, 4B, 4C et 2G ;
[Fig. 8A] à [Fig. 8C] représentent d'autres masques de gravure pouvant être utilisés pour accomplir les étapes des figures 4A, 4B, 4C ; et
[Fig. 9] représente une variante de mise en oeuvre du procédé de fabrication selon l'invention.

Pour plus de clarté, les éléments identiques ou similaires sont repérés par des signes de référence identiques sur l'ensemble des figures.

### DESCRIPTION DETAILLEE

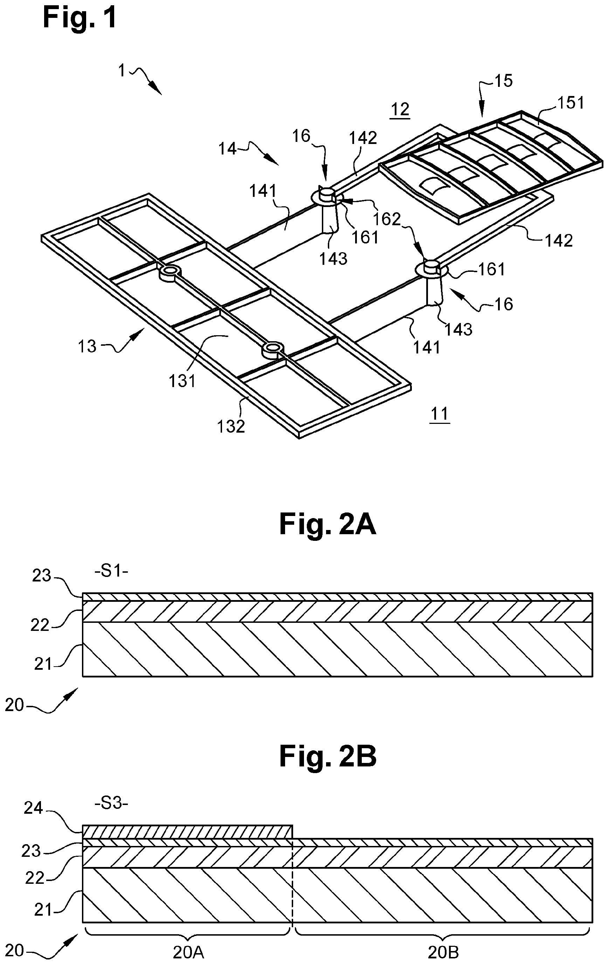

La figure 1 montre un exemple de transducteur électroacoustique 1, de type microphone à détection capacitive, dont on cherche à simplifier la fabrication.

Le transducteur électroacoustique 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du transducteur électroacoustique 1 sont soumises à des pressions différentes. Elles sont isolées l'une de l'autre de manière étanche.

L'élément mobile 13, appelé ci-après piston, est en contact avec la première zone 11. Il comprend une membrane 131 et une structure de rigidification 132 de la membrane, aussi appelée squelette ou armature. La membrane 131 du piston 13 a ici pour rôle de récolter sur toute sa surface une différence de pression entre ses deux faces, pour en déduire une variation de la pression atmosphérique.

La membrane 131 du piston 13 délimite en partie un volume fermé dit de référence, où règne une pression de référence. Elle sépare ce volume de référence d'une cavité ouverte sur l'environnement extérieur, ici l'air. Une face de la membrane 131 est donc soumise à la pression de référence et une face opposée de la membrane 131 est soumise à la pression atmosphérique (dont on souhaite détecter la variation dans le cas d'un microphone).

La première zone 11 peut correspondre à la cavité ouverte sur l'environnement extérieur, et donc être soumise à la pression atmosphérique. Alternativement, la première zone 11 peut être le volume de référence soumis à la pression de référence.

En outre, dans cet exemple particulier, le transducteur électroacoustique 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

La deuxième zone 12 est une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 10 mbar, et de préférence sous vide.

Le dispositif de transmission 14 est monté mobile en rotation par rapport au bâti, au moyen d'une ou plusieurs articulations pivot 16. Le dispositif de transmission 14 comprend au moins un premier bras de transmission 141 s'étendant dans la première zone 11, au moins un deuxième bras de transmission 142 s'étendant dans la deuxième zone 12 et au moins un arbre de transmission 143 s'étendant en partie dans la première zone 11 et en partie dans la deuxième zone 12. Dans l'exemple de la figure 1, le dispositif de transmission 14 comprend deux premiers bras de transmission 141, deux deuxièmes bras de transmission 142 et deux arbres de transmission 143, chaque arbre de transmission 143 reliant un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

L'arbre de transmission 143 est par exemple en forme de cylindre droit. Les bras de transmission 141-142 ont de préférence la forme d'une poutre de section rectangulaire, avec une dimension (longueur) bien supérieure aux autres (largeur et épaisseur). Le piston 13 a par exemple une forme rectangulaire. Les premiers bras de transmission 141 s'étendent de préférence perpendiculairement à un côté du piston 13, avantageusement un grand côté. Ils peuvent être ancrés à l'intérieur de la périphérie du piston 13, comme cela est représenté par la figure 1, par exemple au moyen d'une première extrémité de forme cylindrique.

Chaque articulation pivot 16 comprend de préférence un élément d'isolation étanche 161, traversé par un arbre de transmission 143, et deux lames 162 alignées, qui s'étendent entre l'arbre de transmission 143 et le bâti. L'élément d'isolation étanche 161 se présente par exemple sous la forme d'une membrane d'étanchéité. Il assure l'étanchéité entre la première zone 11 et la deuxième zone 12 au niveau de l'articulation pivot 16. Les lames 162 sont dimensionnées de sorte à pouvoir se déformer en torsion et permettre la rotation du dispositif de transmission 14. Elles sont de préférence disposées de façon diamétralement opposée par rapport à l'arbre de transmission 143. De préférence, l'élément d'isolation étanche 161 est tel qu'il se déforme également sous l'effet du déplacement en rotation du dispositif de transmission 14.

Le bâti peut notamment comprendre un support (formé par un premier substrat), une couche structurelle (par exemple en silicium) disposée sur le support et un capot rapporté sur la couche structurelle (par exemple formé par un deuxième substrat).

La structure de rigidification 132 de la membrane du piston 13 comprend avantageusement à sa périphérie un rebord qui s'étend dans une direction perpendiculaire à la membrane 131. Ce rebord augmente le chemin de l'air autour du piston et réduit les fuites entre l'environnement extérieur et le volume fermé servant de référence.

Les figures 2A à 2H représentent des étapes S1, S3 à S9 d'un procédé de fabrication du transducteur électrostatique 1. Ces figures montrent de quelle façon le piston 13 peut être formé et désolidarisé du bâti. Seulement une partie du transducteur électrostatique, au voisinage de la périphérie du piston 13, est donc représentée. Dans un souci de simplification, il ne sera fait référence qu'à un seul premier bras de transmission 141, une seule articulation pivot 16, une seule membrane d'étanchéité 161..., étant entendu que tous les éléments d'un même type peuvent être formées simultanément.

[Fig. 2A] La première étape S1 représentée par la figure 2A consiste à fournir un empilement de couches 20 servant de matériau de départ à la réalisation du transducteur. L'empilement 20 comprend successivement un substrat 21, une première couche sacrificielle 22 et une première couche structurelle 23, aussi appelée « couche mince ».

Le substrat 21 sert notamment à réaliser le premier bras de transmission 141 et une partie du bâti (le support). Il présente initialement une épaisseur qui peut être comprise entre 500 µm et 700 µm. Le substrat 21 peut être en un matériau semiconducteur, par exemple le silicium.

La première couche structurelle 23 sert à réaliser la membrane 131 du piston 13. Elle peut également servir à réaliser la membrane d'étanchéité 161 de l'articulation pivot 16 et/ou l'électrode mobile 151 des moyens de détection capacitive 15. Elle présente une épaisseur inférieure à celle du substrat 21, de préférence comprise entre 100 nm et 10 µm, par exemple égale à 1 µm. Elle est de préférence constituée du même matériau que le substrat, par exemple le silicium.

La première couche sacrificielle 22 a vocation à disparaître en partie lors de la réalisation du transducteur. Cette couche est notamment utile pour la délimitation du premier bras de transmission 141. Elle peut également servir d'entrefer inférieur dans la zone de détection capacitive du transducteur. Elle peut également permettre de lier mécaniquement le substrat et la première couche structurelle. La première couche sacrificielle 21 peut être constituée d'un matériau diélectrique, de préférence un nitrure de silicium ou un oxyde de silicium, par exemple le dioxyde de silicium (SiO₂). Son épaisseur est par exemple comprise entre 100 nm et 10 µm.

L'empilement 20 peut notamment être une structure multicouche de type silicium sur isolant ou SOI (« Silicon On Insulator » en anglais), communément appelée substrat SOI.

Bien que non représentée par les figures, le procédé de fabrication comprend en outre une étape S2 de gravure de la première couche structurelle 23. Cette étape de gravure de la première couche structurelle 23 peut notamment servir à former des trous de libération de l'électrode mobile 151 (pour laisser s'infiltrer ultérieurement la solution de gravure de la première couche sacrificielle 22).

[Fig. 2B] A l'étape S3 de la figure 2B, une deuxième couche sacrificielle 24 est formée sur la première couche structurelle 23 dans une première zone 20A de l'empilement 20. Pour ce faire, la deuxième couche sacrificielle 24 peut être d'abord déposée de façon à recouvrir entièrement la première couche structurelle 23 puis gravée partiellement dans une deuxième zone 20B de l'empilement 20, par exemple au travers d'un masque en résine formé par photolithographie. La gravure de la deuxième couche sacrificielle 24 est de préférence sélective par rapport à la première couche structurelle 23. La deuxième couche sacrificielle 24 est avantageusement formée du même matériau diélectrique que la première couche sacrificielle 22, par exemple un oxyde de silicium. Son épaisseur peut être comprise entre 100 nm et 10 µm.

La deuxième couche sacrificielle 24 peut servir d'entrefer supérieur pour la détection capacitive. La gravure de la deuxième couche sacrificielle 24 peut entrainer la gravure de la première couche sacrificielle 22, là où la première couche structurelle 23 a préalablement été gravée (non représenté sur les figures).

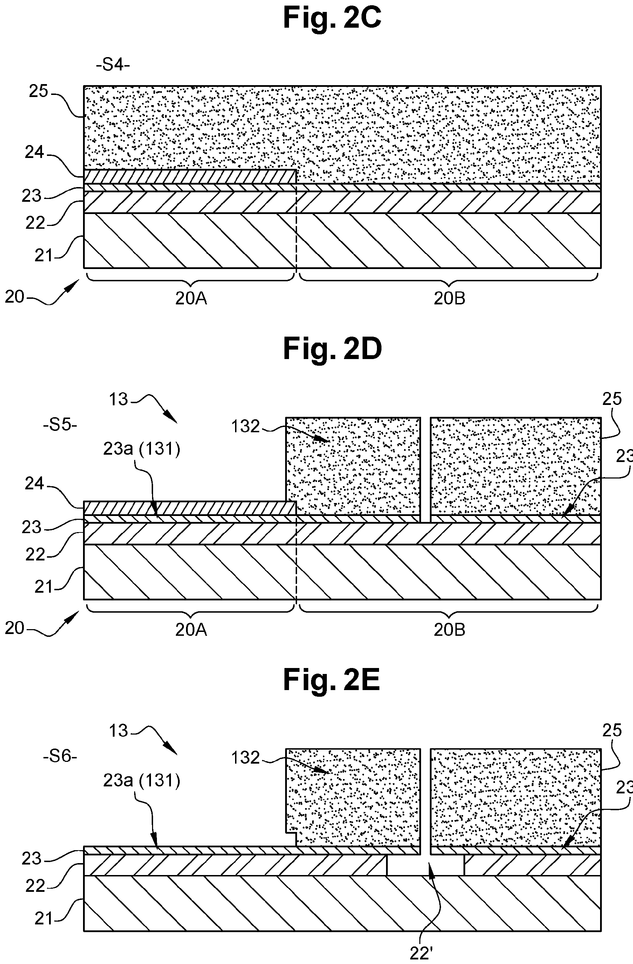

[Fig. 2C] A l'étape S4 de la figure 2C, une deuxième couche structurelle 25 est déposée sur la première couche structurelle 23 (dans la deuxième zone 20B de l'empilement 20) et sur la deuxième couche sacrificielle 24 (dans la première zone 20A de l'empilement 20), par exemple par épitaxie. La deuxième couche structurelle 25 est destinée à former un ou plusieurs éléments (structurels) du transducteur, en particulier la structure de rigidification 132 du piston 13. Elle est avantageusement formée du même matériau que la première couche structurelle 23, par exemple de silicium. L'épaisseur de la deuxième couche structurelle 25 est de préférence comprise entre 5 µm et 50 µm, par exemple égale à 20 µm.

[Fig. 2D] Puis, lors d'une étape S5 représentée par la figure 2D, la deuxième couche structurelle 25 est gravée de façon à délimiter les contours de la structure de rigidification 132 (détourage du piston) et à alléger le piston 13. Dans la première zone 20A de l'empilement 20, la deuxième couche sacrificielle 24 (ex. en oxyde de silicium) sert de couche d'arrêt à la gravure de la deuxième couche structurelle 25 (ex. en silicium), préservant ainsi la première couche structurelle 23 sous-jacente (ex. en silicium). La gravure de la deuxième couche structurelle 25 est donc sélective par rapport à la deuxième couche sacrificielle 24. En revanche, dans la deuxième zone 20B de l'empilement 20, la gravure de la deuxième couche structurelle 25 pour délimiter la périphérie (ou le contour extérieur) de la structure de rigidification 132 débouche sur la première couche structurelle 23. La gravure de la deuxième couche structurelle 25 n'étant pas sélective par rapport à la première couche structurelle 23 (mais uniquement par rapport à la première couche sacrificielle 22), la première couche structurelle 23 est gravée en même temps que la deuxième couche structurelle 25 jusqu'à la première couche sacrificielle 22.

Ainsi, au fond de la tranchée correspondant à la périphérie de la structure de rigidification 132, la première couche structurelle 23 a été gravée et la première couche sacrificielle 22 est exposée.

A l'issue de l'étape S5, la première couche structurelle 23 comprend une première partie 23a et une deuxième partie 23b séparées l'une de l'autre. La première partie 23a de la première couche structurelle 23 (à gauche sur la figure 2D) est destinée à former la membrane 131 du piston 13. Elle est recouverte par la deuxième couche sacrificielle 24 et par une portion désolidarisée de la deuxième couche structurelle 25 formant la structure de rigidification 132 du piston 13.

La technique de gravure employée à l'étape S5 de la figure 2D est avantageusement la gravure ionique réactive profonde (ou DRIE, pour « Deep Reactive Ion Etching » en anglais).

[Fig. 2E] En référence à la figure 2E, le procédé de fabrication comprend ensuite une étape S6 de gravure de la deuxième couche sacrificielle 24 de façon à exposer (partiellement) la première partie 23a de la première couche structurelle 23 (autrement dit de façon à exposer une première face de la membrane 131). Cette étape S6 peut être qualifiée de première étape de libération du piston 13.

La gravure de la deuxième couche sacrificielle 24 est de préférence une gravure isotrope sélective par rapport au substrat 21, à la première couche structurelle 23 et à la deuxième couche structurelle 25. La deuxième couche sacrificielle 24 est de préférence gravée chimiquement, par exemple en plongeant l'empilement dans un bain d'acide fluorhydrique (HF) en phase liquide ou vapeur (dans le cas d'une couche en oxyde de silicium) pendant un temps maîtrisé.

En revanche, une portion de la première couche sacrificielle 22 située à l'aplomb de la périphérie de la structure de rigidification 132 est gravée en même temps que la deuxième couche sacrificielle 24, ce qui forme une cavité 22' dans la première couche sacrificielle 22. La gravure peut être contrôlée en temps de sorte que cette cavité 22' soit peu étendue.

La gravure des couches sacrificielles 22 et 24 peut également servir à libérer l'électrode mobile 151 des moyens de détection capacitive 15 (avant qu'elle ne soit enfermée dans la chambre sous atmosphère contrôlée).

Bien que non représentée par les figures, le procédé de fabrication peut comprendre ensuite une étape de report d'un capot sur la deuxième couche structurelle 25, formant ainsi la chambre sous atmosphère contrôlée, c'est-à-dire la deuxième zone 12. Le capot peut être réalisé par usinage d'un substrat en silicium. Il peut notamment être fixé à la deuxième couche structurelle 25 par collage direct (par exemple Si-Si) ou par scellement eutectique (par exemple Au-Si).

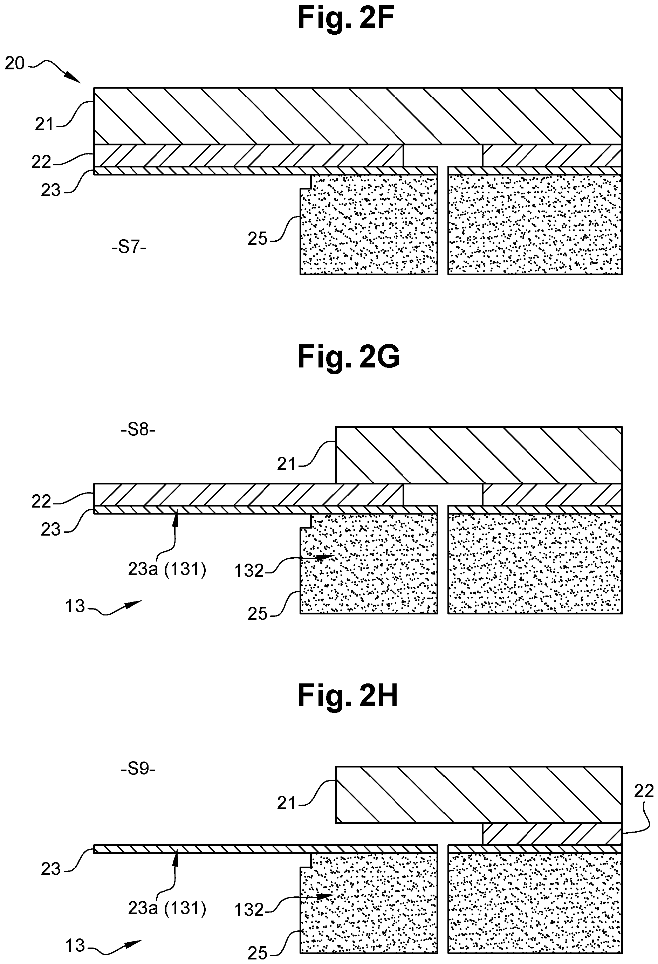

[Fig. 2F] Puis, à l'étape S7 de la figure 2F, l'assemblage formé par l'empilement de couches 20 et le capot (non représenté) est retourné, pour faciliter la gravure ultérieure du substrat 21. Après ce retournement, le substrat 21 est avantageusement aminci, par exemple par gravure DRIE, broyage (« grinding » en anglais) et/ou polissage mécano-chimique (« Chemical mechanical polishing », CMP), de préférence jusqu'à atteindre une épaisseur comprise entre 30 µm à 300 µm, soit l'épaisseur souhaitée pour le premier bras de transmission 141.

[Fig. 2G] L'étape S8 de la figure 2G consiste à graver le substrat 21 (éventuellement aminci) jusqu'à la première couche sacrificielle 22 de façon à créer un accès jusqu'au piston 13 et à délimiter, dans une zone non représentée sur la figure 2F, le premier bras de transmission. La gravure du substrat est de préférence sélective par rapport à la première couche sacrificielle 22. Le substrat 21 peut être gravé par DRIE.

Comme cela est illustré sur la figure 2G, la gravure du substrat 21 pour créer un accès vers la face arrière du piston 13 peut être inscrite à l'intérieur de la périphérie du piston 13, de façon à ne pas déboucher sur la cavité 22' formée à l'étape S6 (cf. Fig. 2E) par la gravure partielle (et involontaire) de la première couche sacrificielle 22. Ainsi, la gravure de l'étape S8 ne s'étend pas au piston 13 comprenant la première partie 23a de la première couche structurelle 23 (membrane 131) et la portion désolidarisée de la deuxième couche structurelle 25 (structure de rigidification 132). A l'intérieur de la périphérie du piston 13, la première couche sacrificielle 22 (ex. en oxyde de silicium) sert de couche d'arrêt à la gravure du substrat 21 (ex. en silicium), préservant ainsi la première partie 23a de la première couche structurelle 23 sous-jacente (ex. en silicium).

Enfin, à l'étape S9 (cf. [Fig. 2H]), la première couche sacrificielle 22 est gravée de façon à découvrir la première partie 23a de la première couche structurelle 23 (autrement dit de façon à exposer une deuxième face opposée de la membrane 131) et la désolidariser du substrat 21. A l'issue de l'étape S9, le piston 13 est libre de se déplacer. L'étape S9 peut donc être qualifiée de deuxième étape de libération du piston 13.

La gravure de la première couche sacrificielle 22 est de préférence une gravure isotrope sélective par rapport au substrat 21, à la première couche structurelle 23 et à la deuxième couche structurelle 25. La première couche sacrificielle 22 est de préférence gravée chimiquement, par exemple en plongeant l'assemblage dans un bain d'acide fluorhydrique (HF) en phase liquide ou vapeur (dans le cas d'une couche en oxyde de silicium) pendant un temps maîtrisé.

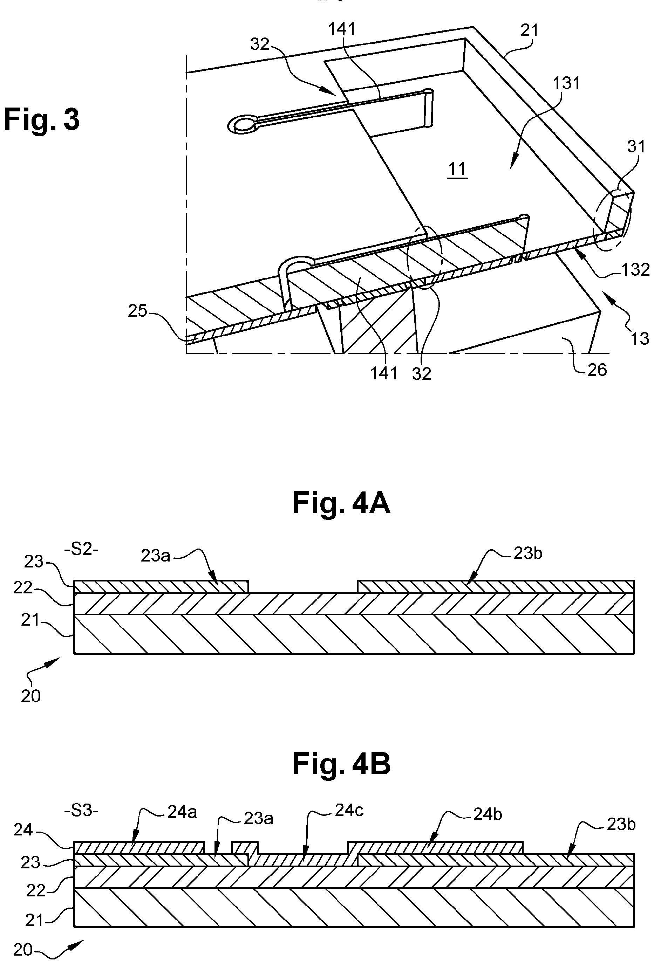

La figure 3 est une vue en perspective de l'assemblage après la deuxième étape de libération du piston S9 (Fig. 2H), coupée selon le plan de symétrie d'un bras de transmission 141. Une partie du capot 26 rapporté sur la deuxième couche structurelle 25 y est représentée.

La première région 31 située à la périphérie de la structure de rigidification 132 est celle représentée en coupe par la figure 2H.

Cette figure montre que la projection verticale (i.e. perpendiculaire au substrat) du premier bras de transmission 141 traverse la périphérie de la structure de rigidification 132 du piston 13. Or à la verticale de cette périphérie se trouve la cavité 22' formée par la gravure de la première couche sacrificielle 22.

Ainsi, dans une deuxième région 32 de l'empilement autour d'une intersection entre la projection (ou la position) du premier bras de transmission 141 et la périphérie de la structure de rigidification 132, la gravure du substrat 21 coïncide avec la gravure (subie) de la première couche sacrificielle 22. La première couche sacrificielle 22 ne peut donc plus servir de couche d'arrêt à la gravure du substrat 21. Cette gravure n'est pas interrompue et s'étend à la première couche structurelle 23 et à la deuxième couche structurelle 25. Un tel phénomène est problématique car il crée des fuites d'air importantes entre la première zone 11 situé d'un côté de la première couche structurelle 23 et le volume situé du côté opposée de la première couche structurelle 23 (ici sous le capot 26). Ce problème de fuites se pose naturellement à chaque premier bras de transmission 141, lorsque le dispositif de transmission en compte plusieurs.

Pour remédier à ce problème, les étapes S2, S3, S5 et S6 du procédé de fabrication décrit précédemment sont accomplies d'une façon différente, au moins au voisinage de chaque intersection entre la projection d'un premier bras de transmission 141 et la périphérie de la structure de rigidification 132.

Les figures 4A à 4D illustrent en vue de coupe de quelle façon les étapes S2, S3, S5 et S6 sont mises en oeuvre dans chaque deuxième région 32 (contenant l'intersection entre la projection d'un premier bras de transmission 141 et la périphérie de la structure de rigidification 132).

[Fig. 4A] La figure 4A représente l'étape S2 de gravure de la première couche structurelle 23. Une portion de la première couche structurelle 23 est gravée de façon à séparer, au moins localement (c.-à-d. dans la deuxième région 32), la première partie 23a et la deuxième partie 23b de la première couche structurelle 23. Pour rappel, la première partie 23a de la première couche structurelle 23 est destinée à former la membrane 131 du piston. Ainsi, la membrane 131 est au moins partiellement détourée lors de cette étape S2.

[Fig. 4B] Puis, à l'étape S3 de la figure 4B, la deuxième couche sacrificielle 24 est formée sur l'empilement 20. L'étape S3 peut être accomplie de sorte que la deuxième couche sacrificielle 24 comporte une première portion 24a disposée sur la première partie 23a de la première couche structurelle 23 et une deuxième portion 24b espacée de la première portion 24a. La deuxième portion 24b de la deuxième couche sacrificielle 24 est déposée sur la première couche structurelle 23 (ici sur la deuxième partie 23b) et s'étend jusqu'à l'endroit où la première couche structurelle 23 a été gravée.

La deuxième couche sacrificielle 24 comporte en outre une troisième portion 24c disposée sur la première couche sacrificielle 22 entre les première et deuxième parties 23a-23b de la première couche structurelle 23 (à l'endroit où la première couche structurelle 23 a été gravée). La troisième portion 24c est adjacente à la deuxième portion 24b. Elle occupe tout l'espace entre les première et deuxième parties 23a-23b de la première couche structurelle 23.

Les première, deuxième et troisième portions 24a-24c de la deuxième couche sacrificielle 24 sont de préférence formées par gravure d'une couche diélectrique préalablement déposée sur la première couche structurelle 23, la gravure étant sélective par rapport à la première couche structurelle 23. Le dépôt de la deuxième couche sacrificielle 24 peut être conforme, de sorte que les première, deuxième et troisième portions 24a-24c présentent la même épaisseur. A l'inverse, le dépôt peut être planarisant s'il est suivi par un polissage mécano-chimique.

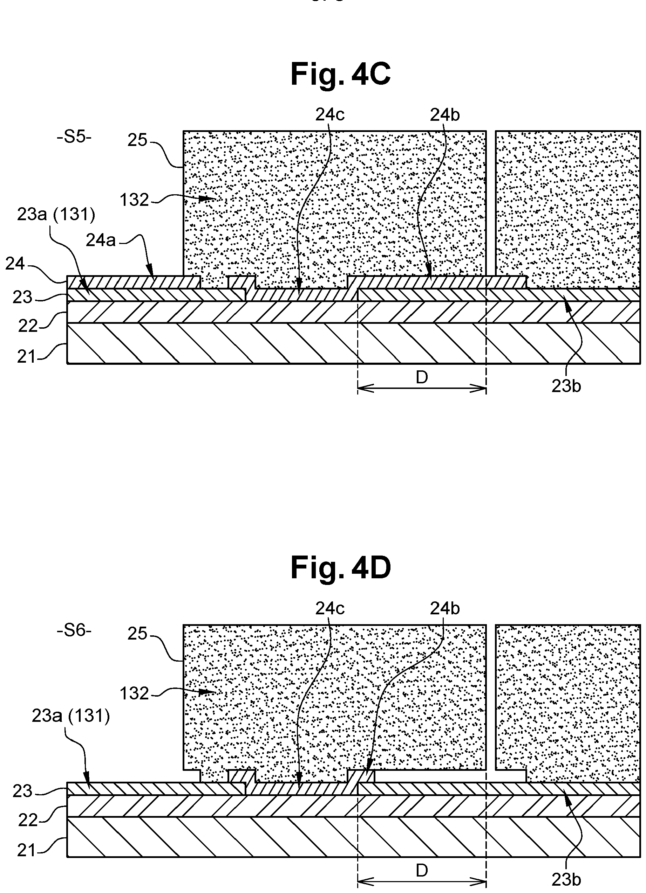

[Fig. 4C] En référence à la figure 4C, l'étape S5 de gravure de la deuxième couche structurelle 25 (pour alléger le piston et délimiter la structure de rigidification 132) est accomplie de sorte que la tranchée correspondant à la périphérie de la structure de rigidification 132 débouche sur la deuxième portion 24b de la deuxième couche sacrificielle 24. La deuxième portion 24b de la deuxième couche sacrificielle 24 sert ainsi de couche d'arrêt à la gravure. Elle empêche la première couche structurelle 23 d'être gravée et la première couche sacrificielle 22 d'être exposée (comme sur la figure 2D).

A l'étape suivante S6 de gravure de la deuxième couche sacrificielle 24 (cf. [Fig. 4D]), la première portion 24a peut être ainsi entièrement éliminée sans que la première couche sacrificielle 22 ne soit altérée. En effet, la deuxième partie 23b de la première couche structurelle 23 est intacte et protège la première couche sacrificielle 22 sous-jacente. En outre, la deuxième portion 24b de la deuxième couche sacrificielle 24 est consommée pendant le retrait de la première portion 24a. Autrement dit, la deuxième portion 24b a pour effet de ralentir la progression des espèces chimiques responsables de la gravure, de sorte qu'elles n'atteignent jamais la première couche sacrificielle 22.

Le procédé de fabrication se déroule ensuite de la façon décrite en relation avec les figures 2F à 2H (étapes S7-S9).

En éloignant ainsi la gravure de la deuxième couche structurelle 25 de la gravure de la première couche structurelle 23 dans la deuxième région 32 de l'empilement, c'est-à-dire en décorrélant le détourage de la membrane 131 du détourage de sa structure de rigidification 132, la première couche sacrificielle 22 peut être laissée intacte. L'étape S8 de gravure du substrat 21 (pour délimiter le premier bras de transmission 141) n'est alors plus contrainte, car la première couche sacrificielle 22 remplit pleinement son rôle de couche d'arrêt.

La gravure de la deuxième couche structurelle 25 et la gravure de la première couche structurelle 23 sont de préférence décalées d'une distance D comprise entre 0,5 µm et 15 µm (cf. Fig. 4C).

La première portion 24a et la troisième portion 24c de la deuxième couche sacrificielle 24 sont de préférence espacées l'une de l'autre, de sorte que la deuxième couche structurelle 25 (structure de rigidification 132) soit directement en contact avec la première partie 23a de la première couche structurelle 23 (membrane 131).

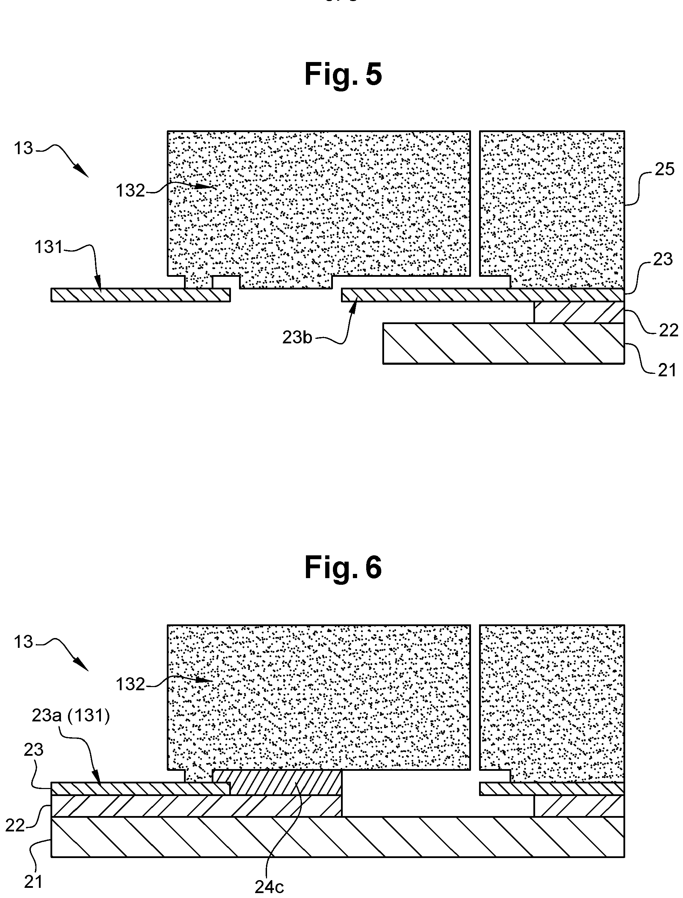

La figure 5 est une vue en coupe de la structure obtenue dans la deuxième région 32 après l'étape S9 de gravure de la première couche sacrificielle 21 (deuxième étape de libération du piston 13), lorsque les étapes S2-S3, S5-S6 des figures 4A-4D ont été accomplies.

Le piston 13 est libre de se déplacer par rapport au bâti, qui comprend ici des portions résiduelles du substrat 21, de la première couche sacrificielle 22 et de la deuxième couche structurelle 25, ainsi que la deuxième partie 23b de la première couche structurelle 23. La structure de rigidification 132 surplombe la deuxième partie 23b de la première couche structurelle 23. La distance entre la structure de rigidification 132 et la deuxième partie 23b de la première couche structurelle 23 est égale à l'épaisseur de la deuxième portion 24b de la deuxième couche sacrificielle 24, typiquement comprise entre 100 nm et 10 µm.

Lors du déplacement du piston 13, de l'air est pincé entre la structure de rigidification 132 et cette portion résiduelle de la première couche structurelle 23. Ce pincement d'air est à l'origine d'un phénomène d'amortissement, appelé « squeeze-film damping » en anglais, qui génère du bruit mécanique et entraîne une diminution des performances du transducteur. La force de ce phénomène d'amortissement est inversement proportionnelle au cube de la distance entre le piston 13 et le bâti (soit ici la deuxième partie 23b de la première couche structurelle 23).

Selon un mode de mise en oeuvre préférentiel du procédé de fabrication, la gravure de la deuxième couche structurelle 25 permettant de délimiter la périphérie de la structure de rigidification 132 (étape S5 ; Fig.4C) est décalée par rapport à la gravure de la première couche structurelle 23 (étape S2 ; Fig.4A) uniquement dans la deuxième région 32 de l'empilement. En dehors de cette deuxième région 32 (c'est-à-dire pour le reste de la périphérie de la structure de rigidification 132), par exemple dans la première région 31 de l'empilement (cf. Fig.3), la première couche structurelle 23 est gravée (étape S2) de sorte que la troisième portion 24c de la deuxième couche sacrificielle 24 (déposée à l'étape S3) s'étende au moins jusqu'à la périphérie de la structure de rigidification 132. Ainsi, il n'existe pas de première couche structurelle 23 à l'endroit où le substrat 21 et la structure de rigidification 132 se superposent. En dehors de la deuxième région 32, la gravure de la deuxième couche structurelle 25 (étape S5) débouche sur la troisième portion 24c de la deuxième couche sacrificielle 24, qui occupe l'espace laissé par gravure de la première couche structurelle 23.

Ce mode de mise en oeuvre préférentiel est illustré par la figure 6. Cette figure montre en vue de coupe schématique la structure obtenue après la première étape de libération du piston (gravure de la deuxième couche sacrificielle 24) dans une région de la périphérie du piston 13 autre que la deuxième région 32 (par exemple la première région 31 de la figure 3).

La deuxième partie 23b de la première couche structurelle 23 ne s'étend pas sous la structure de rigidification 132. La structure de rigidification 132 est séparée du substrat 21 uniquement par la première couche sacrificielle 22 et par la deuxième couche sacrificielle 24 (et plus particulièrement la troisième portion 24c venant occuper l'espace laissée par la gravure de la première couche structurelle 23). Après la deuxième étape de libération du piston (étape S9), la première couche sacrificielle 22 et la deuxième couche sacrificielle 24 auront disparu autour du piston 13, formant un « gap » entre le piston et le bâti plus important que dans la deuxième région 32 de l'empilement (cf. Fig.5). Ce gap est par exemple deux fois plus important lorsque les deux couches sacrificielles 22 et 24 ont des épaisseurs identiques (ce qui est notamment le cas lorsqu'elles servent à réaliser les entrefers de la détection capacitive différentielle).

Le phénomène d'amortissement peut ainsi être réduit tout en résolvant le problème des fuites d'air spécifique à la deuxième région 32.

On notera qu'en dehors de la deuxième région 32, la deuxième couche sacrificielle 24 ne comporte pas nécessairement de deuxième portion 24b disposée sur la deuxième partie 23b de la première couche structurelle 23.

Dans une variante de mise en oeuvre du procédé de fabrication, la gravure de la deuxième couche structurelle 25 permettant de délimiter la périphérie de la structure de rigidification 132 (étape S5 ; Fig.4C) est décalée par rapport à la gravure de la première couche structurelle 23 (étape S2 ; Fig.4A) sur toute la périphérie de la structure de rigidification 132.

Dans une autre variante de mise en oeuvre du procédé de fabrication, la première couche structurelle 23 est laissée intacte en dehors de la deuxième région 32 à l'étape S2, mais gravée à l'étape S5 en même temps que la deuxième couche structurelle 25. Dans ce cas, la deuxième couche sacrificielle 24 ne comporte ni deuxième portion 24b ni troisième portion 24c. Autrement dit, le procédé de fabrication est accompli en dehors de la deuxième région 32 de la façon décrite en relation avec les figures 2A-2G (puisque le problème de fuites est spécifique à la deuxième région 32).

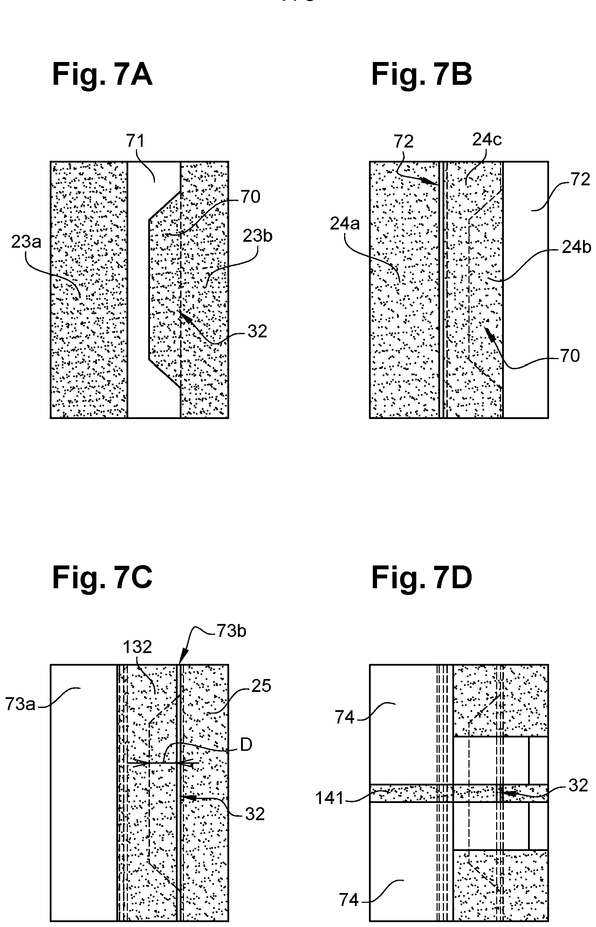

Les figures 7A, 7B, 7C et 7D représentent des exemples de masques (permettant par photolithogravure de réaliser des masques durs ou en résine sur l'empilement de couches) utilisés pour graver respectivement la première couche structurelle 23 (étape S2), la première couche sacrificielle 24 (étape S3), la deuxième couche structurelle 25 (étape S5) et le substrat 21 (étape S8), dans le mode de mise en oeuvre préférentiel du procédé de fabrication.

[Fig. 7A] Le masque de la figure 7A comprend une ouverture (ou évidement) 71 pour graver une portion de la première couche structurelle 23. De chaque côté de l'ouverture 71 se trouvent des parties pleines du masque correspondant aux première et deuxième parties 23a-23b de la première couche structurelle 23. L'ouverture 71 est configurée de sorte que la deuxième partie 23b de la première couche structurelle 23 forme un décroché 70 dans la deuxième région 32, le décroché 70 étant disposé en regard de la première partie 23a de la première couche structurelle 23. Ce décroché 70, aussi appelé languette, est le moyen utilisé ici pour décaler (localement) la gravure de la première couche structurelle 23 et la gravure de la deuxième couche structurelle 25. Le décroché 70 peut être formé par une protubérance (ou saillie) de la deuxième partie 23b de la première couche structurelle 23.

[Fig. 7B] Le masque de la figure 7B comprend deux ouvertures 72 permettant la gravure de la deuxième couche sacrificielle 24. Il montre (en vue de dessus) la disposition de la première portion 24a, la deuxième portion 24b et la troisième portion 24c de la deuxième couche sacrificielle 24 par rapport à la portion gravée de la première couche structurelle 23 (désormais en traits pointillés). On constate que la deuxième portion 24b recouvre bien la languette 70.

[Fig. 7C] Le masque de la figure 7C comprend deux ouvertures 73a-73b pour simultanément alléger le piston et délimiter la structure de rigidification 132 dans la deuxième couche structurelle 25. Dans la deuxième région 32, l'ouverture 73b correspondant à la périphérie de la structure de rigidification 132 est décalée (de la distance D) par rapport à l'ouverture 71 du masque de gravure de la première couche structurelle 23. En revanche, en dehors de la deuxième région 32, les ouvertures 73b et 71 sont alignées l'une sur l'autre (elles peuvent être aussi juxtaposées).

[Fig. 7D] Le masque de la figure 7D comprend deux ouvertures 74 (qui communiquent par ailleurs) pour délimiter le premier bras de transmission 141 dans le substrat. Le premier bras de transmission 141 traverse bien la périphérie de la structure de rigidification 132 (deuxième région 32) au niveau de la languette 70.

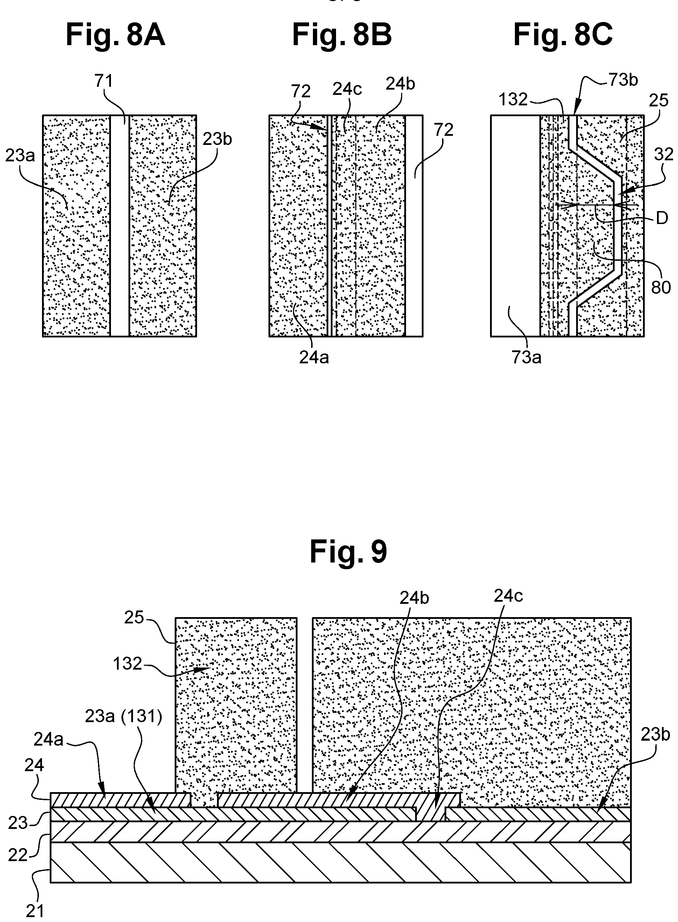

Dans une variante de mise en oeuvre du procédé de fabrication représentée par les figures 8A-8C, la gravure entre la première couche structurelle 23 et la gravure de la deuxième couche structurelle 25 sont éloignées l'une de l'autre au moyen d'un décroché 80 de la structure de rigidification 132, plutôt que le décroché 70 de la deuxième partie 23b de la première couche structurelle 23. Le décroché 80 de la structure de rigidification 132 fait face à la partie restante de la deuxième couche structurelle 25.

Les figures 8A, 8B et 8C montrent des masques pouvant être utilisés pour graver respectivement la première couche structurelle 23 (étape S2), la première couche sacrificielle 24 (étape S3) et la deuxième couche structurelle 25 (étape S5) selon cette variante de mise en oeuvre. La gravure du substrat 21 (étape S8) n'étant pas impactée, le masque de la figure 7D peut à nouveau être utilisé.

L'ouverture 71 du masque utilisé pour graver la première couche structurelle 23 et représenté par la figure 8A est avantageusement rectiligne.

[Fig. 8B] La deuxième portion 24b de la deuxième couche sacrificielle 24, représentée par une partie pleine du masque de la figure 8B, peut être plus large que dans le mode de mise en oeuvre préférentiel des figures 7A-7D (en fonction de la distance D souhaitée).

[Fig. 8C] Enfin, comme représenté par la figure 8C, l'ouverture 73b du masque de gravure de la deuxième couche structurelle 25 est configurée pour former le décroché 80 de la structure de rigidification 132.

Dans un mode de mise en oeuvre représenté par la figure 9, la gravure de la couche structurelle 25 peut être décalée par rapport à la gravure de la première couche structurelle 23 (au moyen d'un décroché de la première couche structurelle 23 ou d'un décroché de la deuxième couche structurelle 25) du côté du piston 13, plutôt que du côté du bâti. La deuxième portion 24b de la deuxième couche sacrificielle 24, sur laquelle s'arrête la gravure de la deuxième couche structurelle 25, est alors disposée sur la première partie 23a de la première couche structurelle 23. La membrane 131 du piston 13 s'étend alors au-delà de la structure de rigidification 132 dans la deuxième région 32.

Le procédé de fabrication de transducteur électroacoustique selon l'invention a été décrit en prenant pour exemple un microphone à détection capacitive (Fig.1), dont une face est soumise à la pression atmosphérique et l'autre face soumise à une pression de référence. Le procédé de fabrication décrit en relation avec les figures 2A-2H et 4A-4D, est cependant applicable à d'autres types de microphone et à d'autres types de transducteur électroacoustique, notamment un haut-parleur (émetteur sonore) ou un émetteur ultrasonore.

De façon plus générale, un microphone comprend dans la deuxième zone 12 (chambre à atmosphère contrôlée) des moyens de mesure d'un mouvement du dispositif de transmission et/ou d'une force appliquée au dispositif de transmission. Ces moyens de mesure comprennent par exemple une poutre vibrante (microphone à détection résonante).

Dans le cas d'un haut-parleur ou d'un émetteur ultrasonore, un actionneur (par exemple capacitif) remplace les moyens de mesure dans la deuxième zone 22. L'actionneur met en mouvement la première extrémité du deuxième bras de transmission 142. Ce mouvement est transmis par le dispositif de transmission 14 au piston 13 solidaire de la première extrémité du premier bras de transmission 141. Le mouvement de la membrane 131 du piston 13 permet d'émettre un son (ou des ultrasons).

## Revendications

1. Procédé de fabrication d'un transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
procédé comprenant les étapes suivantes :
- prévoir (S1) un empilement (20) comprenant successivement un substrat (21), une première couche sacrificielle (22) et une première couche structurelle (23) ;
- graver (S2) la première couche structurelle (23) jusqu'à la première couche sacrificielle (22) de façon à séparer une première partie (23a) de la première couche structurelle et une deuxième partie (23b) de la première couche structurelle, la première partie (23a) de la première couche structurelle étant destinée à former la membrane (131) de l'élément mobile (13) ;
- former (S3) une deuxième couche sacrificielle (24) comprenant :
∘ une première portion (24a) disposée sur la première partie (23a) de la première couche structurelle (23) ;
∘ une deuxième portion (24b) espacée de la première portion (24a) et disposée sur la première couche structurelle (23) ; et
∘ une troisième portion (24c) adjacente à la deuxième portion (24b) et disposée sur la première couche sacrificielle (22) entre les première et deuxième parties (23a-23b) de la première couche structurelle (23) ;
- former (S4) une deuxième couche structurelle (25) sur la deuxième couche sacrificielle (24) ;
- graver (S5) la deuxième couche structurelle (25) de façon à délimiter la structure de rigidification (132) de l'élément mobile (13) et de façon à exposer la première portion (24a) de la deuxième couche sacrificielle (24) ;
- graver (S6) la deuxième couche sacrificielle (24) de façon à exposer la première partie (23a) de la première couche structurelle (23) ;
- graver (S8) le substrat (21) jusqu'à la première couche sacrificielle (22) de façon à délimiter le premier bras de transmission (141) ; et
- graver (S9) la première couche sacrificielle (22) de façon à rendre mobile la première partie (23a) de la première couche structurelle (23) ;
procédé dans lequel la gravure de la première couche structurelle (23) et la gravure de la deuxième couche structurelle (25) délimitant la périphérie de la structure de rigidification (132) sont espacées l'une de l'autre dans une région (32) autour de la position du premier bras de transmission (141), de sorte que la deuxième portion (24b) de la deuxième couche sacrificielle (24) serve de couche d'arrêt à la gravure de la deuxième couche structurelle (25).

2. Procédé selon la revendication 1, dans lequel la première couche structurelle (23) est gravée en dehors de ladite région (32) de sorte que la troisième portion (24c) de la deuxième couche sacrificielle (24) s'étende au moins jusqu'à la périphérie de la structure de rigidification (132).

3. Procédé selon l'une des revendications 1 et 2, dans lequel la gravure de la première couche structurelle (23) et la gravure de la deuxième couche structurelle (25) sont espacées l'une de l'autre au moyen d'un décroché (70) de la première couche structurelle (23).

4. Procédé selon l'une quelconque des revendications 1 à 3, dans lequel la gravure de la première couche structurelle (23) et la gravure de la deuxième couche structurelle (25) sont espacées l'une de l'autre au moyen d'un décroché (80) de la deuxième couche structurelle (25).

5. Procédé selon l'une quelconque des revendications 1 à 4, dans lequel la deuxième portion (24b) de la deuxième couche sacrificielle (24) est disposée sur la deuxième partie (23b) de la première couche structurelle (23).

6. Procédé selon l'une quelconque des revendications 1 à 4, dans lequel la deuxième portion (24b) de la deuxième couche sacrificielle (24) est disposée sur la première partie (23a) de la première couche structurelle (23).

7. Procédé selon la revendication 1, comprenant en outre, après l'étape (S6) de gravure de la deuxième couche sacrificielle (24) et avant l'étape (S8) de gravure du substrat (21), les étapes suivantes :
- disposer un capot (26) sur la deuxième couche structurelle (25), formant ainsi un assemblage ; et
- retourner (S7) l'assemblage.

8. Procédé selon l'une quelconque des revendications 1 à 7, dans lequel l'empilement (20) est une structure multicouche de type silicium sur isolant (SOI).

9. Procédé selon l'une quelconque des revendications 1 à 8, dans lequel le substrat (21) est en silicium, la première couche sacrificielle (22) est en oxyde de silicium et la première couche structurelle (23) est en silicium.

10. Procédé selon l'une quelconque des revendications 1 à 9, dans lequel la deuxième couche sacrificielle (24) est en oxyde de silicium.

11. Procédé selon l'une quelconque des revendications 1 à 10, dans lequel la première couche structurelle (23) présente une épaisseur comprise entre 100 nm et 10 µm.

12. Transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
la membrane (131) étant formée par une première partie (23a) d'une première couche structurelle (23), la structure de rigidification (132) étant formée par une première partie d'une deuxième couche structurelle (25) disposée sur la première couche structurelle (23), le bâti comprenant une première partie d'un substrat (21), une deuxième partie (23b) de la première couche structurelle (23) et une deuxième partie de la deuxième couche structurelle (25),
**caractérisé en ce que** :
le premier bras de transmission (141) est formé d'une deuxième partie du substrat (21), et
l'une des première et deuxième parties de la première couche structurelle (23) présente un décroché (70) en regard de l'autre des première et deuxième parties, le décroché étant situé dans une région (32) autour d'une intersection entre la position du premier bras de transmission (141) et la périphérie de la structure de rigidification (132).

13. Transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
la membrane (131) étant formée par une première partie (23a) d'une première couche structurelle (23), la structure de rigidification (132) étant formée par une première partie d'une deuxième couche structurelle (25) disposée sur la première couche structurelle (23), le bâti comprenant une première partie d'un substrat (21), une deuxième partie (23b) de la première couche structurelle (23) et une deuxième partie de la deuxième couche structurelle (25),
**caractérisé en ce que** :
le premier bras de transmission (141) est formé d'une deuxième partie du substrat (21), et
l'une des première et deuxième parties de la deuxième couche structurelle (25) présente un décroché (80) en regard de l'autre des première et deuxième parties, le décroché étant situé dans une région (32) autour d'une intersection entre la position du premier bras de transmission (141) et la périphérie de la structure de rigidification (132).

14. Transducteur selon l'une des revendications 12 et 13, comprenant un dispositif de transmission (14) d'un mouvement et d'une force entre une première zone (11) et une deuxième zone (12) à atmosphère contrôlée, les première et deuxième zones (11, 12) étant isolées l'une de l'autre de manière étanche, le dispositif de transmission (14) comprenant, outre le premier bras de transmission (141) qui s'étend dans la première zone (11), un deuxième bras de transmission (142) s'étendant dans la deuxième zone (12).

## Patentansprüche

1. Verfahren zur Herstellung eines elektroakustischen Wandlers (1), umfassend:
- einen Rahmen;
- ein in Bezug auf den Rahmen bewegliches Element (13), wobei das bewegliche Element (13) eine Membran (131) und eine Struktur zur Versteifung (132) der Membran umfasst;
- einen ersten Übertragungsarm (141), wobei das bewegliche Element (13) mit einem Ende des ersten Übertragungsarms (141) gekoppelt ist;
Verfahren, das die folgenden Schritte umfasst:
- Vorsehen (S1) einer Schichtung (20), die nacheinander ein Substrat (21), eine erste Opferschicht (22) und eine erste Strukturschicht (23) umfasst;
- Ätzen (S2) der ersten Strukturschicht (23) bis zur ersten Opferschicht (22), um einen ersten Teil (23a) der ersten Strukturschicht und einen zweiten Teil (23b) der ersten Strukturschicht zu trennen, wobei der erste Teil (23a) der ersten Strukturschicht dazu bestimmt ist, die Membran (131) des beweglichen Elements (13) zu bilden;
- Bilden (S3) einer zweiten Opferschicht (24), umfassend:
∘ einen ersten Abschnitt (24a), der auf dem ersten Teil (23a) der ersten Strukturschicht (23) angeordnet ist;
∘ einen zweiten Abschnitt (24b), der von dem ersten Abschnitt (24a) beabstandet ist und auf der ersten Strukturschicht (23) angeordnet ist; und
∘ einen dritten Abschnitt (24c), der an den zweiten Abschnitt (24b) angrenzt und auf der ersten Opferschicht (22) zwischen dem ersten und dem zweiten Teil (23a-23b) der ersten Strukturschicht (23) angeordnet ist;
- Bilden (S4) einer zweiten Strukturschicht (25) auf der zweiten Opferschicht (24);
- Ätzen (S5) der zweiten Strukturschicht (25), um die Versteifungsstruktur (132) des beweglichen Elements (13) zu begrenzen und um den ersten Abschnitt (24a) der zweiten Opferschicht (24) freizulegen;
- Ätzen (S6) der zweiten Opferschicht (24), um den ersten Abschnitt (23a) der ersten Strukturschicht (23) freizulegen;
- Ätzen (S8) des Substrats (21) bis zur ersten Opferschicht (22), um den ersten Übertragungsarm (141) zu begrenzen; und
- Ätzen (S9) der ersten Opferschicht (22), um den ersten Teil (23a) der ersten Strukturschicht (23) beweglich zu machen;
Verfahren, bei dem das Ätzen der ersten Strukturschicht (23) und das Ätzen der zweiten Strukturschicht (25), die den Umfang der Versteifungsstruktur (132) begrenzt, in einem Bereich (32) um die Position des ersten Übertragungsarms (141) herum voneinander beabstandet sind, so dass der zweite Abschnitt (24b) der zweiten Opferschicht (24) als Stoppschicht für das Ätzen der zweiten Strukturschicht (25) fungiert.

2. Verfahren nach Anspruch 1, bei dem die erste Strukturschicht (23) außerhalb des Bereichs (32) geätzt wird, so dass sich der dritte Abschnitt (24c) der zweiten Opferschicht (24) mindestens bis zum Umfang der Versteifungsstruktur (132) erstreckt.

3. Verfahren nach einem der Ansprüche 1 und 2, bei dem das Ätzen der ersten Strukturschicht (23) und das Ätzen der zweiten Strukturschicht (25) mittels eines Absatzes (70) der ersten Strukturschicht (23) voneinander beabstandet sind.

4. Verfahren nach einem der Ansprüche 1 bis 3, bei dem das Ätzen der ersten Strukturschicht (23) und das Ätzen der zweiten Strukturschicht (25) mittels eines Absatzes (80) der zweiten Strukturschicht (25) voneinander beabstandet sind.

5. Verfahren nach einem der Ansprüche 1 bis 4, bei dem der zweite Abschnitt (24b) der zweiten Opferschicht (24) auf dem zweiten Teil (23b) der ersten Strukturschicht (23) angeordnet wird.

6. Verfahren nach einem der Ansprüche 1 bis 4, bei dem der zweite Abschnitt (24b) der zweiten Opferschicht (24) auf dem ersten Teil (23a) der ersten Strukturschicht (23) angeordnet wird.

7. Verfahren nach Anspruch 1, ferner nach dem Schritt (S6) des Ätzens der zweiten Opferschicht (24) und vor dem Schritt (S8) des Ätzens des Substrats (21) die folgenden Schritte umfassend:
- Anordnen einer Abdeckung (26) auf der zweiten Strukturschicht (25) und so eine Verbindung bilden; und
- Umdrehen (S7) der Verbindung.

8. Verfahren nach einem der Ansprüche 1 bis 7, bei dem die Schichtung (20) eine Mehrschichtstruktur vom Typ Silizium auf einem Isolator (SOI) ist.

9. Verfahren nach einem der Ansprüche 1 bis 8, bei dem das Substrat (21) aus Silizium besteht, die erste Opferschicht (22) aus Siliziumoxid ist und die erste Strukturschicht (23) aus Silizium ist.

10. Verfahren nach einem der Ansprüche 1 bis 9, bei dem die zweite Opferschicht (24) aus Siliziumoxid besteht.

11. Verfahren nach einem der Ansprüche 1 bis 10, bei dem die erste Strukturschicht (23) eine Dicke zwischen 100 nm und 10 µm aufweist.

12. Elektroakustischer Wandler (1), umfassend:
- einen Rahmen;
- ein in Bezug auf den Rahmen bewegliches Element (13), wobei das bewegliche Element (13) eine Membran (131) und eine Versteifungsstruktur (132) der Membran umfasst;
- einen ersten Übertragungsarm (141), wobei das bewegliche Element (13) mit einem Ende des ersten Übertragungsarms (141) gekoppelt ist;
wobei die Membran (131) durch einen ersten Abschnitt (23a) einer ersten Strukturschicht (23) gebildet wird, die Versteifungsstruktur (132) durch einen ersten Abschnitt einer zweiten Strukturschicht (25) gebildet wird, die auf der ersten Strukturschicht (23) angeordnet ist, wobei der Rahmen einen ersten Abschnitt eines Substrats (21), einen zweiten Abschnitt (23b) der ersten Strukturschicht (23) und einen zweiten Abschnitt der zweiten Strukturschicht (25) umfasst,
**dadurch gekennzeichnet, dass**:
der erste Übertragungsarm (141) aus einem zweiten Teil des Substrats (21) gebildet ist, und
einer der ersten und zweiten Teile der ersten Strukturschicht (23) einen Absatz (70) gegenüber dem anderen der ersten und zweiten Teile aufweist,
wobei der Absatz in einem Bereich (32) um einen Schnittpunkt zwischen der Position des ersten Übertragungsarms (141) und dem Umfang der Versteifungsstruktur (132) angeordnet ist.

13. Elektroakustischer Wandler (1), umfassend:
- einen Rahmen;
- ein in Bezug auf den Rahmen bewegliches Element (13), wobei das bewegliche Element (13) eine Membran (131) und eine Struktur zur Versteifung (132) der Membran umfasst;
- einen ersten Übertragungsarm (141), wobei das bewegliche Element (13) mit einem Ende des ersten Übertragungsarms (141) gekoppelt ist;
wobei die Membran (131) durch einen ersten Abschnitt (23a) einer ersten Strukturschicht (23) gebildet wird, die Versteifungsstruktur (132) durch einen ersten Abschnitt einer zweiten Strukturschicht (25) gebildet wird, die auf der ersten Strukturschicht (23) angeordnet ist, wobei der Rahmen einen ersten Abschnitt eines Substrats (21), einen zweiten Abschnitt (23b) der ersten Strukturschicht (23) und einen zweiten Abschnitt der zweiten Strukturschicht (25) umfasst,
**dadurch gekennzeichnet, dass**:
der erste Übertragungsarm (141) aus einem zweiten Teil des Substrats (21) gebildet ist, und
einer der ersten und zweiten Teile der zweiten Strukturschicht (25) einen Absatz (80) aufweist, der dem anderen der ersten und zweiten Teile gegenüberliegt, wobei der Absatz in einem Bereich (32) um einen Schnittpunkt zwischen der Position des ersten Übertragungsarms (141) und dem Umfang der Versteifungsstruktur (132) angeordnet ist.

14. Wandler nach einem der Ansprüche 12 und 13, umfassend eine Vorrichtung (14) zur Übertragung von Bewegung und Kraft zwischen einem ersten Bereich (11) und einem zweiten Bereich (12) mit kontrollierter Atmosphäre, wobei der erste und der zweite Bereich (11, 12) völlig dicht zueinander isoliert sind, wobei die Übertragungsvorrichtung (14) neben dem ersten Übertragungsarm (141), der sich in den ersten Bereich (11) erstreckt, einen zweiten Übertragungsarm (142) umfasst, der sich in den zweiten Bereich (12) erstreckt.

## Claims

1. Method for manufacturing an electro-acoustic transducer (1) comprising:
- a frame;
- an element (13) movable with respect to the frame, the movable element (13) comprising a membrane (131) and a structure (132) for rigidifying the membrane;
- a first transmission arm (141), the movable element (13) being coupled to an end of the first transmission arm (141);
method comprising the following steps:
- providing (S1) a stack (20) comprising successively a substrate (21), a first sacrificial layer (22) and a first structural layer (23);
- etching (S2) the first structural layer (23) to the first sacrificial layer (22) in such a way as to separate a first portion (23a) of the first structural layer and a second portion (23b) of the first structural layer, the first portion (23a) of the first structural layer being intended to form the membrane (131) of the movable element (13);
- forming (S3) a second sacrificial layer (24) comprising:
∘ a first portion (24a) arranged on the first portion (23a) of the first structural layer (23);
∘ a second portion (24b) spaced from the first portion (24a) and arranged on the first structural layer (23); and
∘ a third portion (24c) adjacent to the second portion (24b) and arranged on the first sacrificial layer (22) between the first and second portions (23a-23b) of the first structural layer (23);
- forming (S4) a second structural layer (25) on the second sacrificial layer (24);
- etching (S5) the second structural layer (25) in such a way as to delimit the rigidification structure (132) of the movable element (13) and in such a way as to expose the first portion (24a) of the second sacrificial layer (24);
- etching (S6) the second sacrificial layer (24) in such a way as to expose the first portion (23a) of the first structural layer (23);
- etching (S8) the substrate (21) to the first sacrificial layer (22) in such a way as to delimit the first transmission arm (141); and
- etching (S9) the first sacrificial layer (22) in such a way as to render moveable the first portion (23a) of the first structural layer (23);
method wherein the etching of the first structural layer (23) and the etching of the second structural layer (25) delimiting the periphery of the rigidification structure (132) are spaced from one another in a region (32) around the position of the first transmission arm (141), in such a way that the second portion (24b) of the second sacrificial layer (24) serves as a stop layer to the etching of the second structural layer (25).

2. Method according to claim 1, wherein the first structural layer (23) is etched outside said region (32) in such a way that the third portion (24c) of the second sacrificial layer (24) extends at least to the periphery of the rigidification structure (132).

3. Method according to one of claims 1 and 2, wherein the etching of the first structural layer (23) and the etching of the second structural layer (25) are spaced from one another by means of an inset (70) of the first structural layer (23).

4. Method according to any of claims 1 to 3, wherein the etching of the first structural layer (23) and the etching of the second structural layer (25) are spaced from one another by means of an inset (80) of the second structural layer (25).

5. Method according to any of claims 1 to 4, wherein the second portion (24b) of the second sacrificial layer (24) is arranged on the second portion (23b) of the first structural layer (23).

6. Method according to any of claims 1 to 4, wherein the second portion (24b) of the second sacrificial layer (24) is arranged on the first portion (23a) of the first structural layer (23).

7. Method according to claim 1, further comprising, after the step (S6) of etching the second sacrificial layer (24) and before the step (S8) of etching the substrate (21), the following steps:
- arranging a cover (26) on the second structural layer (25), thus forming an assembly; and
- turning over (S7) the assembly.

8. Method according to any of claims 1 to 7, wherein the stack (20) is a multilayer structure of the silicon-on-insulator (SOI) type.

9. Method according to any of claims 1 to 8, wherein the substrate (21) is made from silicon, the first sacrificial layer (22) is made from silicon oxide and the first structural layer (23) is made from silicon.

10. Method according to any of claims 1 to 9, wherein the second sacrificial layer (24) is made from silicon oxide.

11. Method according to any of claims 1 to 10, wherein the first structural layer (23) has a thickness comprised between 100 nm and 10 µm.

12. Electro-acoustic transducer (1) comprising:
- a frame;
- an element (13) movable with respect to the frame, the movable element (13) comprising a membrane (131) and a structure (132) for rigidifying the membrane;
- a first transmission arm (141), the movable element (13) being coupled to an end of the first transmission arm (141);
the membrane (131) being formed by a first portion (23a) of a first structural layer (23), the rigidification structure (132) being formed by a first portion of a second structural layer (25) arranged on the first structural layer (23), the frame comprising a first portion of a substrate (21), a second portion (23b) of the first structural layer (23) and a second portion of the second structural layer (25),
**characterized in that**:
the first transmission arm (141) is formed by a second portion of the substrate (21), and
one of the first and second portions of the first structural layer (23) has an inset (70) facing the other of the first and second portions, the inset being located in a region (32) around an intersection between the position of the first transmission arm (141) and the periphery of the rigidification structure (132).

13. Electro-acoustic transducer (1) comprising:
- a frame;
- an element (13) movable with respect to the frame, the movable element (13) comprising a membrane (131) and a structure (132) for rigidifying the membrane;
- a first transmission arm (141), the movable element (13) being coupled to an end of the first transmission arm (141);
the membrane (131) being formed by a first portion (23a) of a first structural layer (23), the rigidification structure (132) being formed by a first portion of a second structural layer (25) arranged on the first structural layer (23), the frame comprising a first portion of a substrate (21), a second portion (23b) of the first structural layer (23) and a second portion of the second structural layer (25),
**characterized in that**:
the first transmission arm (141) is formed by a second portion of the substrate (21), and
one of the first and second portions of the second structural layer (25) has an inset (80) facing the other of the first and second portions, the inset being located in a region (32) around an intersection between the position of the first transmission arm (141) and the periphery of the rigidification structure (132).

14. Transducer according to one of claims 12 and 13, comprising a device (14) for transmitting a movement and a force between a first zone (11) and a second zone (12) with a controlled atmosphere, the first and second zones (11, 12) being insulated from one another in a sealed manner, the transmitting device (14) comprising, in addition to the first transmission arm (141) that extends in the first zone (11), a second transmission arm (142) extending in the second zone (12).
